# EUROPÄISCHE PATENTSCHRIFT

(11) **EP 0 561 775 B1**
(45) Veröffentlichungstag und Bekanntmachung des Hinweises auf die Patenterteilung: **15.02.1995**
(21) Anmeldenummer: 90900803.9
(22) Anmeldetag: 17.11.1989
(51) Int. Cl.: G11B 11/10, H03K 17/66, H03K 17/04

(54) **SCHALTUNGSANORDNUNG ZUR UMKEHRUNG EINES MAGNETFELDES**
CIRCUIT FOR REVERSING A MAGNETIC FIELD
CIRCUIT POUR INVERSER UN CHAMP MAGNETIQUE

(30) Priorität: 17.11.1988 DE 3838858
(43) Veröffentlichungstag der Anmeldung: 29.09.1993
(73) Patentinhaber: Deutsche Thomson-Brandt GmbH, 78003 Villingen-Schwenningen (DE)
(72) Erfinder: ZUCKER, Friedhelm, D-7733 Mönchweiler (DE); BÜCHLER, Christian, D-7730 VS-Marbach (DE)
(86) Internationale Anmeldenummer: EP8901391
(87) Internationale Veröffentlichungsnummer: WO9005980

(56) Entgegenhaltungen:
- EP-A- 0 227 411
- EP-A- 0 304 298
- EP-A- 0 312 143
- GB-A- 1 376 083
- US-A- 2 972 710
- US-A- 3 400 304
- US-A- 3 602 739
- US-A- 3 770 986
- ELECTRONIC ENGINEER vol.31, Nr. 2, February 1972, RADNOR US page DC-9 Robert S. Olla
- IBM TECHNICAL DISCLOSURE BULLETIN Vol. 11, Nr.10, March 1969, NEW YORK US page 1365 R.J.Froess

## Beschreibung

Die Erfindung betrifft eine Schaltungsanordnung zur Umkehrung eines Magnetfeldes.

Derartige Schaltungsanordnungen werden z.B. in magneto-optischen Aufzeichnungs- und Wiedergabegeräten eingesetzt, um die Magnetisierungsrichtung in der magnetischen Schicht eines magneto-optischen Aufzeichnungsträgers umzukehren.

Ein bekannter magneto-optischer Aufzeichnungsträger ist die magneto-optische Platte, bei der hinter einer lichtdurchlässigen Schicht eine magneto-optische Schicht liegt, auf der Daten aufzeichenbar und von der diese Daten lesbar sind. Es wird zunächst erläutert, wie die Daten auf eine magneto-optische Platte geschrieben werden.

Mittels eines auf die Platte fokussierten Laserstrahls wird die magneto-optische Schicht auf eine Temperatur erhitzt, die in der Nähe der Curie-Temperatur liegt. Meist genügt es jedoch, die magneto-optische Schicht nur etwa bis zur Kompensationstemperatur aufzuheizen, die unter der Curie-Temperatur liegt. Hinter dem Brennpunkt auf der Platte ist ein Elektromagnet angeordnet, der den vom Laserstrahl erhitzten Bereich in die eine oder andere Magnetisierungsrichtung magnetisiert. Weil nach Abschalten des Laserstrahls die erhitzte Stelle wieder unter die Kompensationstemperatur abkühlt, bleibt die vom Elektromagneten festgelegte Magnetisierungsrichtung erhalten. Sie friert sozusagen ein. Auf diese Weise werden die einzelnen Bits in Domänen unterschiedlicher Magnetisierungsrichtung gespeichert. Dabei entspricht z.B. die eine Magnetisierungsrichtung einer Domäne einer logischen Eins, während die entgegengesetzte Magnetisierungsrichtung eine logische Null darstellt.

Zum Lesen der Daten macht man sich den Kerr-Effekt zunutze. Die Polarisationsebene eines linear polarisierten Lichtstrahls wird bei der Reflexion an einem magnetisierten Spiegel um einem meßbaren Winkel gedreht. Je nachdem, in welche Richtung der Spiegel magnetisiert ist, wird die Polarisationsebene des reflektierten Lichtstrahls nach rechts oder links gedreht. Weil aber die einzelnen Domänen auf der Platte wie magnetisierte Spiegel wirken, wird die Polarisationsebene eines abtastenden Lichtstrahls je nach der Magnetisierungsrichtung der gerade abgetasteten Domäne um einen meßbaren Winkel nach links oder rechts gedreht.

Aus der Drehung der Polarisationsebene des von der Platte reflektierten Lichtstrahls erkennt die optische Abtastvorrichtung, welches Bit vorliegt, eine logische Eins oder eine logische Null.

Eine bekannte Lösung, um die magneto-optische Schicht in die eine oder andere Richtung zu magnetisieren, sieht eine als Elektromagnet wirkende Schaltungsanordnung mit einer Spule hinter der magneto-optischen Platte vor. Die Spule ist so zu dimensionieren, daß sie den gesamten Bereich, den die optische Abtastvorrichtung überstreicht, umzumagnetisieren vermag. Dieser Bereich ist je nach Typ des Aufzeichnungs- und Wiedergabegerätes z.B. ein radialer oder kreisbogenförmiger Streifen, der vom Plattenrand zum Plattenmittelpunkt verläuft. Weil die Feldstärke auf dem gesamten Streifen einen Mindestwert erreichen muß, um den Streifen ummagnetisieren zu können, fallen der Querschnitt und damit die Induktivität der Spule relativ groß aus.

Bei einer weiteren bekannten Lösung ist die Spule auf der optischen Abtastvorrichtung befestigt. Die Spule kann z.B. um die Objektivlinse der optischen Abtastvorrichtung gewickelt sein. Weil bei dieser Lösung die Spule zusammen mit der optischen Abtastvorrichtung mittels eines Spurregelkreises entlang den Datenspuren auf der magneto-optischen Platte geführt wird, genügen ein geringerer Querschnitt und somit eine kleinere Induktivität, um dieselbe Mindestfeldstärke zu erzeugen, denn es wird nicht ein radialer oder kreisbogenförmiger Streifen, sondern nur ein kleiner beispielsweise kreisförmiger Bereich mit dem nahezu punktförmigen Laserfleck als Mittelpunkt in der magneto-optischen Schicht ummagnetisiert.

In dem Aufsatz "A simple digital tape head driver" von Robert S. Olla, der in Electronic Engineer, Vol. 31, No. 2, Februar 1972, Radnor US auf Seite DC-9 erschienen ist, beschreibt der Autor einen Magnetkopftreiber für ein digitales Bandaufzeichnungsgerät.

Parallel zu einem Schwingkreis liegt eine Reihenschaltung aus der Kollektor-Emitter-Strecke zweier Transistoren, die als elektronische Schalter dienen. Durch je ein Steuersignal an den Basen werden die beiden Transistoren abwechselnd geöffnet und geschlossen, um die Richtung des Stromes durch die Spule im Schwingkreis umzukehren. Dadurch wird die Richtung des Magnetfeldes der Spule umgekehrt.

Aus der US-PS 3 400 304 ist eine weitere Schaltungsanordnung zur Umkehrung eines Magnetfeldes bekannt.

An jedem Anschluß einer Spule ist eine Kapazität angeschlossen. Mittels vier Transistoren, die als elektronische Schalter vorgesehen sind, wird der Spule und einer der beiden Kapazitäten zunächst Energie von einer ersten Spannungsquelle zugeführt. Im nächsten Schritt werden die Spule und diese Kapazität von der ersten Spannungsquelle getrennt, um in dem aus der Spule und der einen Kapazität gebildeten Schwingkreis Resonanz zu erzeugen. Durch Umschalten der Schalter dienenden Transistoren wird die Resonanz im Schwingkreis unterbrochen, damit in der Spule eine Induktionsspannung erzeugt wird.

Anschließend werden der Spule und der anderen Kapazität Energie von einer zweiten Spannungsquelle zugeführt. Die Spule und die andere Kapazität werden von der zweiten Spannungsquelle getrennt, damit jetzt in dem Schwingkreis aus der Spule und der anderen Kapazität Resonanz verursacht wird. Um eine Induktionsspannung in der Spule zu erzeugen, wird durch Umschalten der Schalter die Resonanz im Schwingkreis unterbunden. Es ist jetzt wieder die Ausgangslage erreicht, in der die erste Spannungsquelle der Spule und der einen Kapazität wieder Energie zuführt.

Es ist nun Aufgabe der Erfindung, eine Schaltungsanordnung mit einer Spule so zu gestalten, daß eine sichere und schnelle Umkehrung des Magnetfeldes erzielt wird.

Die Erfindung löst diese Aufgabe mit den im Anspruch 1 angegebenen merkmalen. Eine zweite Lösung der Erfindung ist im Anspruch 2 beschrieben.

Es zeigen
- Figur 1 bis 9: ein erstes Ausführungsbeispiel der Erfindung in verschiedenen Schaltzuständen
- Figur 10: ein Diagramm, in dem die Schaltzustände der steuerbaren Schalter sowie der Strom- und Spannungsverlauf über der Zeit für das erste Ausführungsbeispiel aufgetragen sind
- Figur 11: ein zweites Ausführungsbeispiel der Erfindung
- Figur 12: ein Diagramm, in dem die Schaltzustände der steuerbaren Schalter sowie der Strom- und Spannungsverlauf über der Zeit für das zweite Ausführungsbeispiel aufgetragen sind
- Figur 13: ein erstes Ausführungsbeispiel einer Steuerschaltung zur Ansteuerung der steuerbaren Schalter
- Figur 14: ein Diagramm, in dem die Steuersignale für die steuerbaren Schalter sowie der Strom- und Spannungsverlauf über der Zeit aufgetragen sind
- Figur 15: ein zweites Ausführungsbeispiel einer Steuerschaltung zur Ansteuerung der steuerbaren Schalter
- Figur 16: ein Diagramm, in dem die Steuersignale für die steuerbaren Schalter sowie der Strom- und Spannungsverlauf über der Zeit aufgetragen sind
- Figur 17: ein drittes Ausführungsbeispiel der Erfindung.

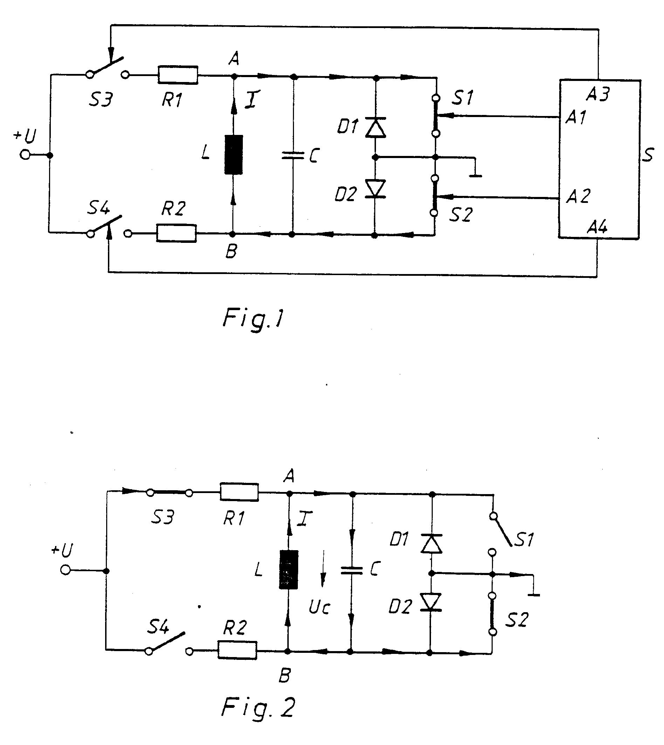

Anhand der Figuren 1 bis 9 wird nun das erste Ausführungsbeispiel der Erfindung beschrieben und anschließend erläutert.

In der Figur 1 liegt parallel zu einem Schwingkreis aus einer Spule L und einer Kapazität C eine Reihenschaltung aus zwei entgegengesetzt gepolten Dioden D1 und D2. Die Diode D1 ist mittels eines steuerbaren Schalters S1, die Diode D2 mittels eines steuerbaren Schalters S2 überbrückbar. Der eine Anschluß A des Schwingkreises ist über eine Reihenschaltung aus einem Widerstand R1 und einem steuerbaren Schalter S3 mit dem einen Pol einer Spannungsquelle +U verbunden, deren anderer Pol mit dem gemeinsamen Verbindungspunkt der beiden Dioden D1 und D2 verbunden ist. Der andere Anschluß B des Schwingkreises ist über eine Reihenschaltung aus einem Widerstand R3 und einem steuerbaren Schalter S4 ebenfalls mit dem einen Pol der Spannungsquelle +U verbunden.

Eine Steuerschaltung S, deren Ausgänge A1 bis A4 mit den Steuereingängen der steuerbaren Schalter S1 bis S4 verbunden ist, öffnet und schließt die steuerbaren Schalter S1 bis S4 in einer zyklischen Reihenfolge, die nun anhand der Figuren 1 bis 10 erläutert wird. Der besseren übersichtlichkeit wegen ist die Steuerschaltung S in den Figuren 2 bis 9 nicht eingezeichnet.

In der Figur 1 sind die steuerbaren Schalter S1 und S2 geschlossen, die steuerbaren Schalter S3 und S4 dagegen geöffnet. Der Einfachheit halber und zum leichteren Verständnis der Erfindung sei angenommen, daß es sich bei der Spule L um eine verlustlose Induktivität handelt, in der bereits magnetische Energie gespeichert ist. Es fließt daher ein Strom I in der angegebenen Pfeilrichtung in dem Stromkreis, den die Spule L und den die beiden steuerbaren Schalter S1 und S2 bilden. Auf die Funktion der Spannungsquelle +U, der steuerbaren Schalter S3 und S4 sowie der Widerstände R1 und R2 wird später eingegangen.

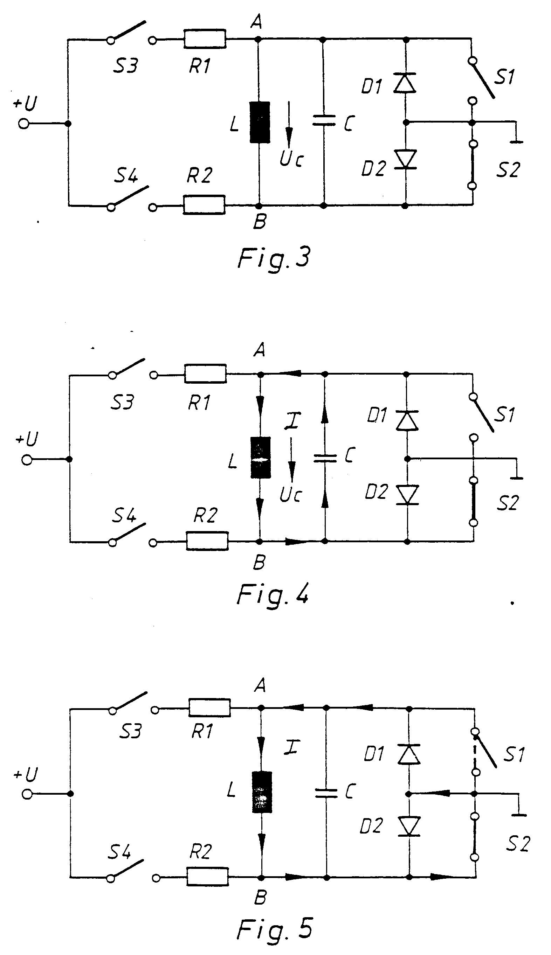

Um die Richtung des Magnetfeldes umzukehren, öffnet die Steuerschaltung S den steuerbaren Schalter S1. Weil der Stromfluß durch den parallel zur Spule L verlaufenden Zweig aus den beiden steuerbaren Schaltern S1 und S2 jetzt unterbrochen ist, fließt der Strom I nun über die Kapazität C, die dadurch aufgeladen wird, wie in Figur 2 gezeigt ist. Während des Ladevorgangs sinkt aber der Strom I durch die Spule, bis er schließlich null wird, wenn die Spannung U_{C} an der Kapazität C am größten wird. Dieser Zustand ist in Figur 3 dargestellt. Weil sich jetzt die Kapazität C zu entladen beginnt, fließt der Strom I nun in die andere Richtung durch die Spule L, wie die Strompfeile in Figur 4 andeuten. Sobald jedoch die Spannung U_{C} an der Kapazität C auf null abgesunken ist, beginnt die Diode D1 zu leiten. Es fließt jetzt der Strom I zwar in der gleichen Richtung weiter durch die Spule L, jedoch nicht mehr über die Kapazität C, sondern über den steuerbaren Schalter S2 und die Diode D1. Dieser Zustand ist in Figur 5 gezeigt.

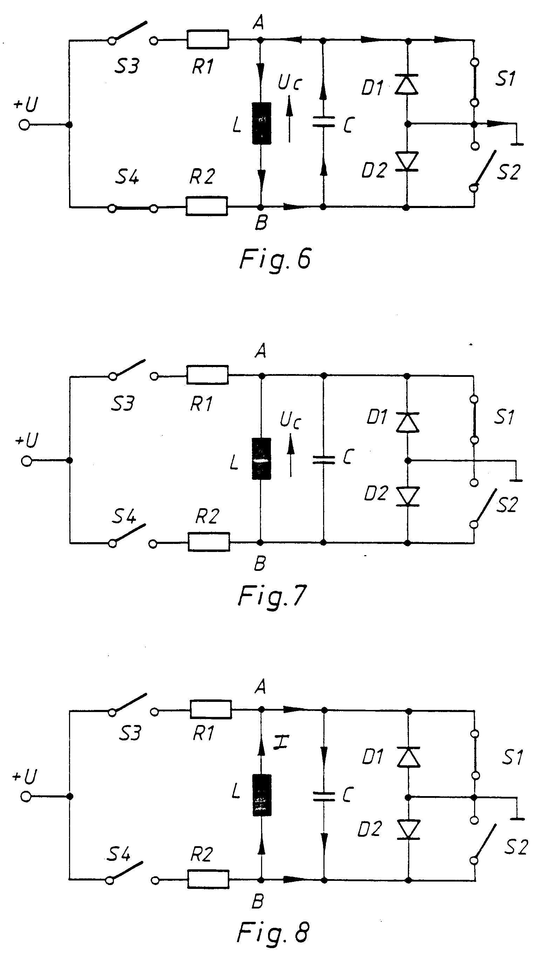

In Figur 6 öffnet die Steuerschaltung S den steuerbaren Schalter S2, während sie gleichzeitig den steuerbaren Schalter S1 schließt. Die Kapazität wird nun entgegengesetzt aufgeladen, bis die Spannung U_{C} an der Kapazität C den größten negativen Wert annimmt. Der Strom I durch die Spule L wird dann null, wie in Figur 7 gezeigt ist.

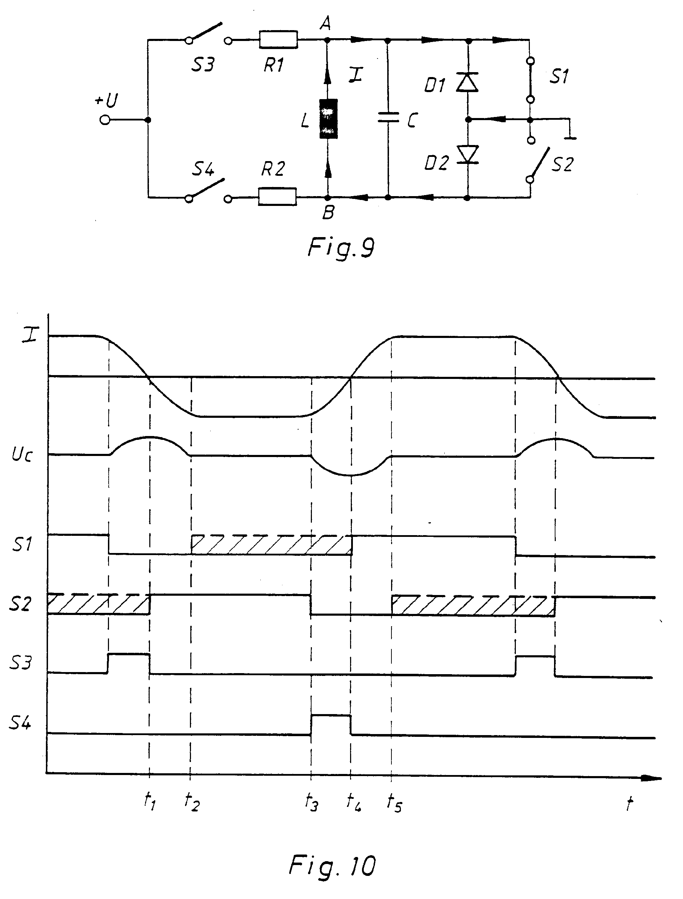

Weil die Kapazität C sich jetzt wieder entlädt, kehrt sich der Stromfluß durch die Spule L um. Dies ist in Figur 8 dargestellt.

Sobald die Spannung U_{C} an der Kapazität C null wird, beginnt die Diode D2 zu leiten. Der Strom I fließt, wie in Figur 9 gezeigt ist, in der Schleife, die aus der Spule L, der Diode D2 und dem steuerbaren Schalter S1 gebildet wird. Die Steuerschaltung S schließt jetzt den steuerbaren Schalter S2; damit ist wieder der in Figur 1 dargestellte Anfangszustand erreicht.

Weil es sich aber bei der Spule L, der Kapazität C, den beiden Dioden D1 und D2 sowie den beiden steuerbaren Schaltern S1 und S2 nicht um verlustfreie, sondern um Bauteile mit ohmschen Verlusten handelt, muß dem Schwingkreis Energie zugeführt werden. Deshalb schließt die Steuerschaltung S den steuerbaren Schalter S3, wenn sie den steuerbaren Schalter S1 öffnet. Wie in Figur 2 gezeigt ist, wird durch diese Maßnahme der Schwingkreis an die Spannungsquelle +U angeschlossen. Ebenso schließt die Steuerschaltung S den steuerbaren Schalter S4, wenn sie den steuerbaren Schalter S1 schließt und den steuerbaren Schalter S2 öffnet. Der Schwingkreis ist nun ebenfalls an die Spannungsquelle +U angeschlossen. Dieser Schaltzustand ist aus Figur 6 ersichtlich.

In der Figur 10 sind der Strom I durch die Spule L, die Spannung U_{C} an der Kapazität C und die Schaltzustände der steuerbaren Schalter S1 bis S4 in Abhängigkeit von der Zeit t gezeichnet. Zum Zeitpunkt t = 0 sind die steuerbaren Schalter S3 und S4 geöffnet, während die steuerbaren Schalter S1 und S2 geschlossen sind. Der steuerbare Schalter S2 kann aber auch geöffnet sein, weil die Diode D2 leitet.

Wie bereits erklärt, wird zur Umkehrung des Magnetfeldes der steuerbare Schalter S1 geöffnet und gleichzeitig der steuerbare Schalter S3 geschlossen. Der Strom I durch die Spule L sinkt ab, während gleichzeitig die Spannung U_{C} an der Kapazität C ansteigt. Wenn der Strom I durch die Spule L null wird, nimmt die Spannung U_{C} ihr Maximum an. Zu diesem Zeitpunkt t₁ wird der steuerbare Schalter S3 wieder geöffnet; der steuerbare Schalter S2 muß spätestens zum Zeitpunkt t₁ geschlossen werden. Der Strom I wird jetzt negativ, während gleichzeitig die Spannung U_{C} auf den Wert null absinkt. Der Strom I hat nun seinen größten negativen Wert. Frühestens zu diesem Zeitpunkt t₂ darf der steuerbare Schalter S1 geschlossen werden. Zum Zeitpunkt t₃ öffnet die Steuerschaltung S den steuerbaren Schalter S2, während sie gleichzeitig den steuerbaren Schalter S4 schließt. Der Strom I sinkt auf null; gleichzeitig wird die Spannung U_{C} an der Kapazität C negativ. Wenn der Strom I null wird, liegt an der Kapazität C die größte negative Spannung U_{C}. Zu diesem Zeitpunkt t₄ wird der steuerbare Schalter S4 wieder geöffnet; der steuerbare Schalter S1 ist spätestens zum Zeitpunkt t₄ zu schließen. Der Strom I steigt weiter an bis zum größten positiven Wert, während gleichzeitig die Spannung U_{C} auf den Wert null absinkt. Der steuerbare Schalter S2 kann zu diesem Zeitpunkt t₅ bereits geschlossen werden. In den schraffierten Bereichen ist die Stellung der Schalter S1 bis S4 beliebig. Die Widerstände R1 und R2 dienen der Begrenzung des Stromes durch den Schwingkreis.

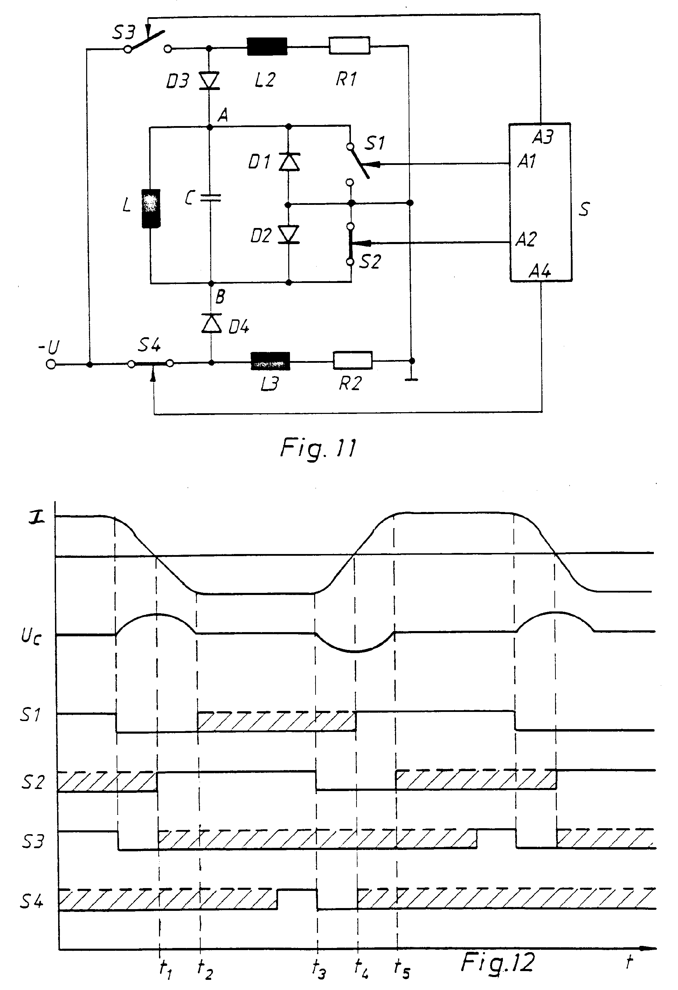

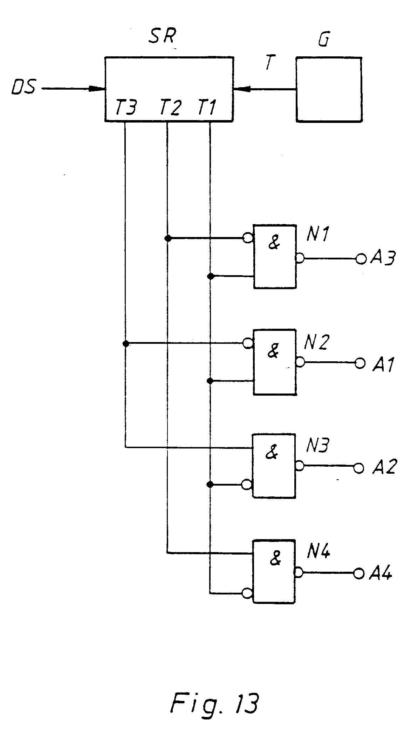

Es wird nun anhand der Figuren 11 und 12 ein zweites Ausführungsbeispiel der Erfindung beschrieben und erläutert.

Das zweite in Figur 11 gezeigte Ausführungsbeispiel unterscheidet sich vom ersten durch eine andere Energiezuführung. Die Parallelschaltung aus dem Schwingkreis, den Dioden D1 und D2 und den steuerbaren Schaltern S1 und S2 ist genauso aufgebaut wie beim ersten Ausführungsbeispiel. Jedoch ist der eine Anschluß A des Schwingkreises mit der einen Elektrode einer Diode D3 verbunden, deren andere Elektrode über einen steuerbaren Schalter S3 mit dem einen Pol einer Versorgungsspannung -U und über eine Reihenschaltung aus einer Induktivität L2 und einem Widerstand R1 mit dem anderen Pol der Versorgungsspannung -U verbunden ist. Auf die gleiche Weise ist der andere Anschluß B des Schwingkreises mit der einen Elektrode einer Diode D4 verbunden, deren andere Elektrode über einen steuerbaren Schaler S4 mit dem einen Pol der Versorgungsspannung -U und über eine Reihenschaltung aus einer Induktivität L3 und einem Widerstand R2 mit dem anderen Pol der Versorgungsspannung -U verbunden ist.

In Figur 12 sind der Strom I durch die Spule L, die Spannung U_{C} an der Kapazität C und die Stellung der steuerbaren Schalter S1 bis S4 über der Zeit t aufgetragen.

Der Stromverlauf und der Spannungsverlauf sowie die Stellung der steuerbaren Schalter S1 und S2 stimmen mit denen aus Figur 10 überein. Die Energiezuführung erfolgt nicht durch unmittelbares Anlegen der Spannung einer Versorgungsspannungsquelle, sondern durch Anlegen einer Induktionsspannung. Die steuerbaren Schalter S3 und S4 werden daher jedesmal kurz geöffnet, wenn die Kapazität C - positiv oder negativ - geladen wird. Die Dioden D3 und D4 sind so gepolt, daß bei geschlossenen steuerbaren Schaltern S3 und S4 Strom durch die Induktivitäten L2 und L3, jedoch nicht in den Schwingkreis fließt.

In der Figur 12 wird nun der steuerbare Schalter S3 zum Zeitpunkt t₁ geöffnet, wenn die Kapazität C positiv geladen wird.

Durch das öffnen des steuerbaren Schalters S3 entsteht an der Induktivität L2 eine Induktionsspannung, die der Kapazität C zugeführt wird. Frühestens zum Zeitpunkt t₂, wenn U_{C} maximal und I null werden, kann der steuerbare Schalter S2 wieder geschlossen werden. Der steuerbare Schalter S4 wird zum Zeitpunkt t₃, wenn die Kapazität C negativ geladen wird, geöffnet. Die an der Induktivität L3 entstehende Induktionsspannung gleicht jetzt die Energieverluste im Schwingkreis aus. Frühestens zum Zeitpunkt t₄, wenn die Spannung U_{C} den größten negativen Wert annimmt, kann der steuerbare Schalter S4 wieder geschlossen werden. In den schraffierten Bereichen ist die Stellung der steuerbaren Schalter S1 bis S4 beliebig. Die Widerstände R1 und R2 wirken wie beim ersten Ausführungsbeispiel als Strombegrenzer. Gegenüber dem ersten Ausführungsbeispiel hat das zweite den Vorteil, daß die hohe Spannung zum Ausgleich der Energieverluste im Schwingkreis nicht mittels eines Netzteils, sondern auf einfache Art und Weise in einer Induktivität erzeugt wird. Die Spannung -U beim zweiten Ausführungsbeispiel kann daher mindestens um den Faktor zehn kleiner gewählt werden als die Spannung +U beim ersten Ausführungsbeispiel.

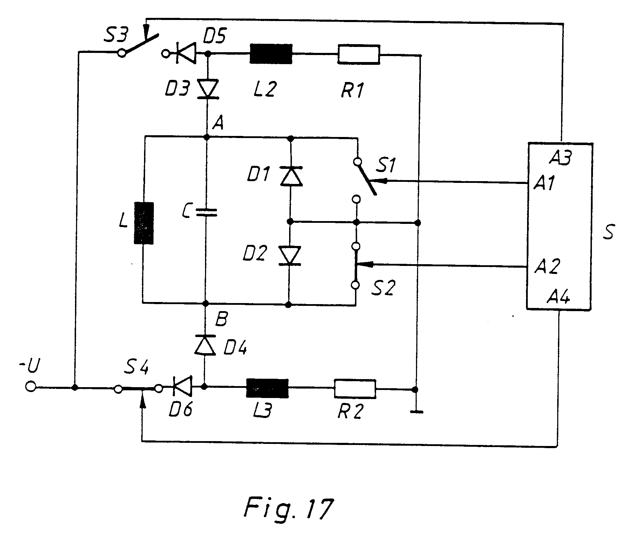

Das in Figur 17 abgebildete dritte Ausführungsbeispiel der Erfindung unterscheidet sich vom zweiten Ausführungsbeispiel aus Figur 11 dadurch, daß zwei weitere Dioden D5 und D6 vorgesehen sind. Die eine zusätzliche Diode, die Diode D5, die entgegengesetzt zur Diode D3 gepolt ist, liegt zwischen dem steuerbaren Schalter S3 und dem gemeinsamen Verbindungspunkt der Diode D3 und der Induktivität L2. Zwischen dem steuerbaren Schalter S4 und dem gemeinsamen Anschluß der Diode D4 und der Induktivität L3 ist die andere zusätzliche Diode, die Diode D6, die entgegengesetzt zur Diode D4 gepolt ist, geschaltet.

Wenn für die steuerbaren Schalter S3 und S4 Transistoren vorgesehen sind, bewirken die Dioden D5 und D6 eine schnellere Entladung der parasitären Kapazität in den Induktivitäten L2 und L3, wie nun am Beispiel der Diode D5 und der Induktivität L2 erläutert wird.

Wenn der steuerbare Schalter S3 geschlossen ist - der dafür vorgesehene Transistor also leitend ist - liegt an der Induktivität L2 die Spannung -U, während der Strom durch die Induktivität L2 linear ansteigt. Sobald der steuerbare Schalter S3 geöffnet wird, d.h. der Transistor sperrt, steigt wegen der Induktionsspannung das Potential an dem einen Anschluß der Induktivität L2, der mit den Dioden D3 und D5 verbunden ist, steil auf einen Maximalwert an, während der Strom durch die Indiktivität L2 auf den Wert Null absinkt. Anschließend sinkt aber das Potential an dem einen Anschluß der Induktivität L2 wieder. Wenn es auf den Wert Null abgefallen ist, erreicht der Strom ein Minimum. Das Potential sinkt nun weiter ab, während gleichzeitig der Strom durch die Induktivität L2 vom Minimum wieder auf den Wert Null ansteigt. Ohne die Diode D5 kann es aber nicht negativ gegenüber dem negativen Pol der Versorgungsspannungsquelle -U werden, weil dann die Diode des als steuerbaren Schalter dienenden Transistors durchschaltet. Daher kann sich ohne die Diode D5 die parasitäre Kapazität der Induktivität L2 nur noch langsam entladen. Wenn der steuerbare Schalter S3 wieder geschlossen wird, ist deshalb die parasitäre Kapazität noch nicht vollständig entladen und die Induktivität L2 daher noch nicht stromlos. Um diesen Nachteil zu vemeiden ist die Diode D5 vorgesehen, denn weil sie den einen Anschluß der Induktivität L2 gegen den negativen Pol der Versorgungsspannungquelle -U sperrt, kann das Potential an diesem Knoten negativ gegenüber dem negativen Pol der Versorgungsspannungsquelle -U werden. Dadurch wird die parasitäre Kapazität der Induktivität L2 schneller entladen und als Folge davon die Induktivität L2 schneller stromlos.

Durch geschickte Dimensionierung der Induktivität L2 und günstige Wahl des Einschaltzeitpunktes des steuerbaren Schalters S3 läßt sich sogar erzielen, daß beim Einschalten des steuerbaren Schalters S3 noch ein Reststrom in der Induktivität L2 in der gleichen Richtung fließt wie der nun von der Versorgungsspannungsquelle -U verursachte Strom. Wegen dieses Reststroms steigt daher der Strom in der Induktivität L2 schneller auf den Maximalwert an, als es bei stromloser Induktivität L2 zum Einschaltzeitpunkt des steuerbaren Schalters S3 der Fall wäre.

Wie bereits erwähnt ist die Erfindung zum Ummagnetisieren der Magnetschicht eines magneto-optischen Aufzeichnungsträgers geeignet.

Auf magneto-optischen CD-Platten sind die Daten nach dem Eight-to-Fourteen-Modulation-Code, abgekürtzt EFM-Code, gespeichert.

In der Figur 13 ist ein erstes Ausführungsbeispiel einer Steuerschaltung zur Ansteuerung der steuerbaren Schalter S1 bis S4 gezeigt, der z.B. die aufzuzeichnenden Daten zugeführt werden.

Der Takt T eines Taktgenerators G und ein digitales Signal DS, das z.B. bei einem CD-Spieler ein EFM-Signal wäre, werden einem Schieberegister SR zugeführt. Am ersten Ausgang T1 des Schieberegisters SR, der mit dem nichtinvertierenden Eingang eines NAND-Gatters N1 und N2 sowie mit dem invertierenden Eingang eines NAND-Gatters N3 und N4 verbunden ist, liegt das digitale Signal DS an. Am zweiten Ausgang T2 des Schieberegisters SR, der mit dem invertierenden Eingang des NAND-Gatters N1 und N4 verbunden ist, wird das um einen Takt verzögerte digitale Signal DS1 abgegriffen. Der dritte Ausgang T3 des Schieberegisters SR, an dem das um zwei Takte verzögerte digitale Signal DS2 abgegeben wird, ist mit dem invertierenden Eingang des NAND-Gatters N2 und N3 verbunden. Am Ausgang des NAND-Gatters N1 ist das Steuersignal für den steuerbaren Schalter S3, am Ausgang des NAND-Gatters N2 das Steuersignal für den steuerbaren Schalter S2, am Ausgang des NAND-Gatters N3 das Steuersignal für den steuerbaren Schalter S1 und am Ausgang des NAND-Gatters N4 das Steuersignal für den steuerbaren Schalter S4 abnehmbar.

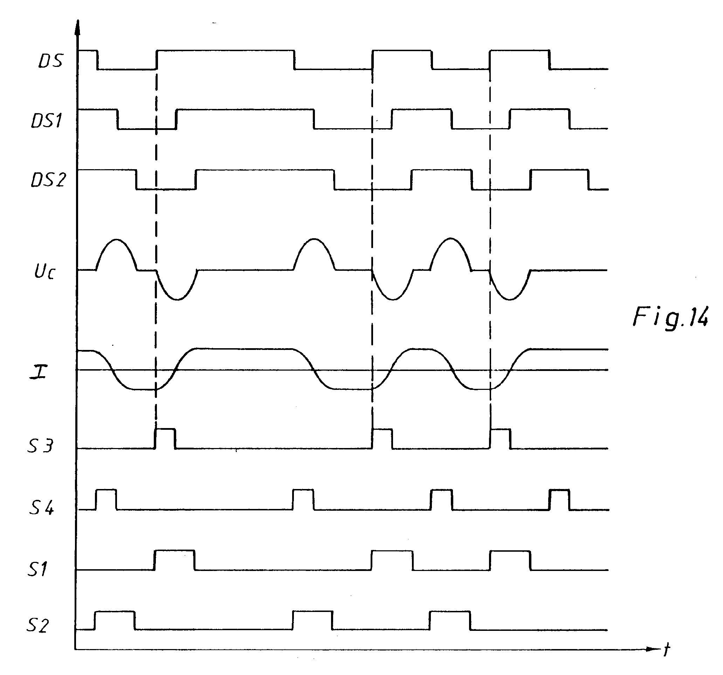

In der Figur 14 sind das digitale Signal DS, das um einen Takt verzögerte digitale Signal DS1, das um zwei Takte verzögerte digitale Signal DS2, der Strom I durch die Spule L, die Spannung U_{C} an der Kapazität C sowie die Steuersignale für die steuerbaren Schalter S1 bis S4 über der Zeit t aufgetragen. Das digitale Signal kann z.B. ein nach dem EFM-Code aufgebautes Datensignal sein.

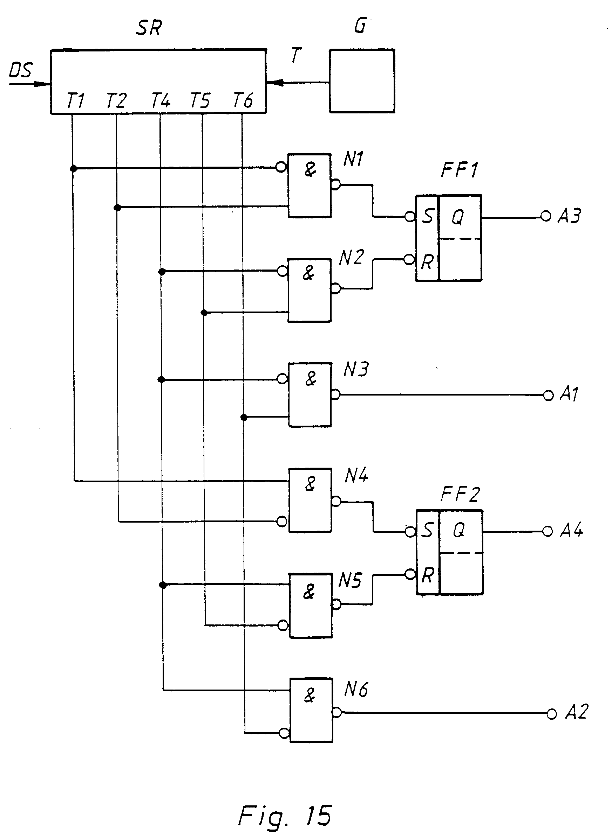

In der Figur 15 ist ein zweites Ausführungsbeispiel einer Steuerschaltung zur Ansteuerung der steuerbaren Schalter S1 bis S4 gezeigt.

Das Datensignal DS wird ebenfalls einem Schieberegister SR zugeführt, das von einem Taktgenerator G mit dem Takt T getaktet wird. Der Ausgang T1 des Schieberegisters SR, an dem das um einen Takt verzögerte Datensignal DS1 abgegeben wird, ist mit dem invertierenden Eingang eines NAND-Gatters N1 und mit dem nichtinvertierenden Eingang eines NAND-Gatters N4 verbunden. Der Ausgang T2 des Schieberegisters SR, der das um zwei Takte verzögerte Datensignal DS2 liefert, ist mit dem nichtinvertierenden Eingang des NAND-Gatters N1 und mit dem invertierenden Eingang des NAND-Gatters N4 verbunden. Der Ausgang T4, an dem das um vier Takte verzögerte Datensignal DS4 abgreifbar ist, ist mit dem invertierenden Eingang eines NAND-Gatters N2 und mit dem invertierenden Eingang eines NAND-Gatters N3 verbunden. Der Ausgang T5, der das um fünf Takte verzögerte Datensignal DS5 abgibt, ist mit dem nichtinvertierenden Eingang des NAND-Gatters N2 und mit dem invertierenden Eingang eines NAND-Gatters N5 verbunden. Der Ausgang T6, der das um sechs Takte verzögerte Datensignal DS6 liefert, ist mit dem nichtinvertierenden Eingang des NAND-Gatters N3 und mit dem invertierenden Eingang des NAND-Gatters N6 verbunden. Am Q-Ausgang eines RS-Flip-Flops FF1, dessen Setzeingang mit dem Ausgang des NAND-Gatters N1 und dessen Rücksetzeingang mit dem Ausgang des NAND-Gatters N2 verbunden ist, ist das Steuersignal für den steuerbaren Schalter S3 abgreifbar. Am Q-Ausgang eines RS-Flip-Flops FF2, dessen Setzeingang mit dem Ausgang des NAND-Gatters N4 und dessen Rücksetzeingang mit dem Ausgang des NAND-Gatters N5 verbunden ist, ist das Steuersignal für den steuerbaren Schalter S4 abnehmbar. Das Steuersignal für den steuerbaren Schalter S1 liegt am Ausgang des NAND-Gatters N3, während der Ausgang des NAND-Gatters N6 das Steuersignal für den steuerbaren Schalter S2 liefert. Anstelle von NAND-Gattern können z.B. UND-Gatter verwendet werden, wenn die Flip-Flops auf ansteigende Flanken reagieren.

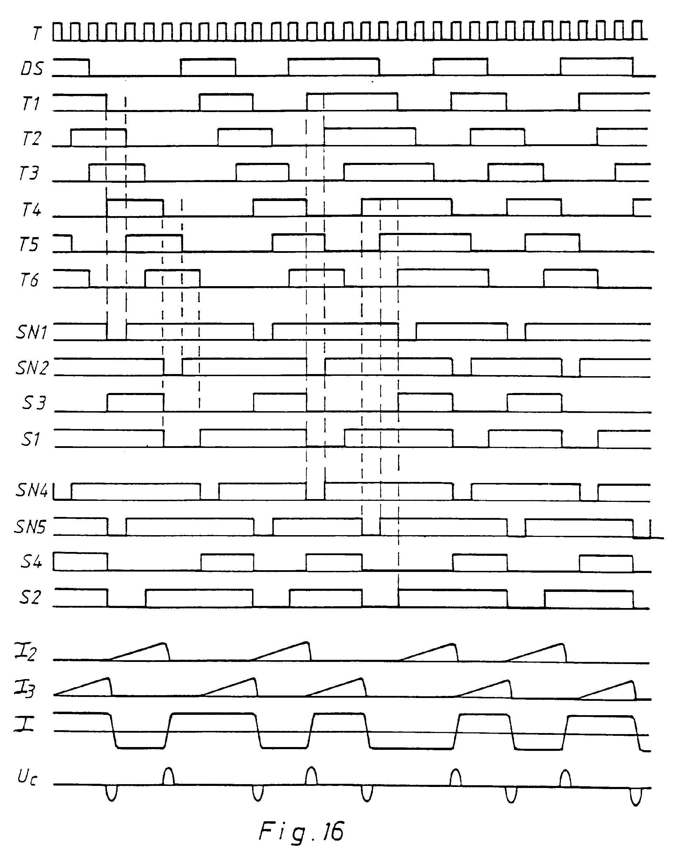

In der Figur 16 sind der Takt T, das Datensignal DS, die Signale DS1 - DS5 an den Ausgängen T1, T2, T4, T5 und T6 des Schieberegisters SR, das Signal SN1 am Ausgang des NAND-Gatters N1, das Signal SN2 am Ausgang des NAND-Gatters N2, das Signal SN4 am Ausgang des NAND-Gatters N4, das Signal SN5 am Ausgang des NAND-Gatters N5, die Signale S1 - S4 zur Ansteuerung der steuerbaren Schalter S1 - S4, der Strom I2 durch die Induktivität L2, der Strom I3 durch die Induktivität L3, der Strom I durch die Spule L und die Spannung U_{C} über der Zeit t aufgetragen. Weil die Funktion eines NAND-Gatters und eines Flip-Flops dem Fachmann bekannt sind, wird auf eine weitere Erläuterung der in Figur 16 gezeichneten Impulsdiagramme verzichtet.

Die Erfindung bietet bei magneto-optischen Aufzeichnungs- und Wiedergabegeräten den Vorteil, daß bereits auf der magneto-optischen Platte aufgezeichnete Daten unmittelbar überschrieben werden können. Dagegen werden bei bekannten magneto-optischen Aufzeichnungs- und Wiedergabegeräten zuerst die alten Daten gelöscht, ehe neue Daten aufgezeichnet werden.

Zu diesem Zweck wird die magneto-optische Schicht an den Stellen, wo die neuen Daten gespeichert werden sollen, vom Laser auf die Kompensationstemperatur erhitzt. Dadurch werden diese Stellen in die eine Richtung magnetisiert. Die Platte wird initialisiert, wie der Fachausdruck für diesen Vorgang lautet. Anschließend wird die Richtung des in der Spule erzeugten Magnetfeldes wieder umgekehrt.

Zum Aufzeichnen der neuen Daten wird die Laserleistung zwischen einem kleinen und großen Wert in Abhängigkeit vom zu speichernden Bit geschaltet. Wird an der zuvor gelöschten Stelle beispielsweise eine logische Null gespeichert, so arbeitet der Laser mit der kleinen Leistung, damit die Kompensationstemperatur nicht erreicht wird. Zum Aufzeichnen einer logischen Eins erhitzt der Laser dagegen die neu zu beschreibende Strelle auf die Kompensationstemperatur, damit diese Stelle von der Spule ummagnetisiert werden kann. Auf diese umständliche Weise werden Daten auf der magneto-optischen Platte zuerst gelöscht, ehe anschließend die neuen Daten aufgezeichnet werden.

Die Erfindung ist nicht nur für magneto-optische Geräte, sondern auch für andere magnetische Aufzeichnungsgeräte geeignet.

## Patentansprüche

1. Schaltungsanordnung zur Umkehrung eines Magnetfeldes, wobei eine Reihenschaltung aus einer ersten und einer zweiten Diode (D1, D2), die entgegengesetzt gepolt sind, parallel zu einem Schwingkreis aus einer Spule (L) und einer Kapazität (C) geschaltet ist, wobei die erste Diode (D1) durch einen ersten steuerbaren Schalter (S1) und die zweite Diode (D2) durch einen zweiten steuerbaren Schalter (S2) überbrückbar ist, wobei zur Umkehrung des Magnetfeldes der erste steuerbare Schalter (S1) geöffnet wird, wobei der zweite steuerbare Schalter (S2) spätestens geschloßen wird, wenn die Spannung (U_{C}) an der Kapazität (C) auf den einer Extremwert angestiegen ist, wobei der erste steuerbare Schalter (S1) frühestens geschloßen wird, wenn die Spannung (U_{C}) an der Kapazität vom einen Extremwert wieder auf null abgesunken ist, wobei zur erneuten Umkehrung des Magnetfeldes der zweite steuerbare Schalter (S2) geöffnet wird, jedoch nicht bevor die Spannung (U_{C}) an der Kapazität (C) vom einen Extremwert auf null abgesunken ist, wobei der erste steuerbare Schalter (S1) spätestens geschlossen wird, wenn die Spannung (U_{C}) an der Kapazität (C) auf den anderen Extremwert angestiegen ist, daß der zweite steuerbare Schalter (S2) frühestens geschloßen wird, wenn die Spannung (U_{C}) an der Kapazität (C) vom anderen Extremwert wieder auf null abgesunken ist, wobei der eine Anschluß (A) des Schwingkreises über einen dritten steuerbaren Schalter (S3) und der andere Anschluß (B) des Schwingkreises über einen vierten steuerbaren Schalter (S4) mit dem einen Pol einer Spannungsquelle (+U) verbunden ist, deren anderer Pol mit dem gemeinsamen Verbindungspunkt der beiden Dioden (D1, D2) verbunden ist, wobei die Steuerschaltung (S) den dritten steuerbaren Schalter (S3) schließt, wenn der erste steuerbare Schalter (S1) geöffnet, der zweite steuerbare Schalter (S2) dagegen geschlossen ist, wobei die Steuerschaltung (S) den dritten steuerbaren Schalter (S3) wieder öffnet, wenn die Kapazität (C) aufgeladen ist, wobei die Steuerschaltung (S) den vierten steuerbaren Schalter (S4) schließt, wenn der zweite steuerbare Schalter (S2) geöffnet, der erste steuerbare Schalter (S1) dagegen geschlossen ist und wobei die Steuerschaltung (S) den vierten steuerbaren Schalter (S4) wieder öffnet, wenn die Kapazität (C) aufgeladen ist.

2. Schaltungsanordnung zur Umkehrung eines Magnerfeldes, wobei eine Reihenschaltung aus einer ersten und einer zweiten Diode (D1, D2), die entgegengesetzt gepolt sind, parallel zu einem Schwingkreis aus einer Spule (L) und einer Kapazität (C) geschaltet ist, wobei die erste Diode (D1) durch einen ersten steuerbaren Schalter (S1) und die zweite Diode (D2) durch einen zweiten steuerbaren Schalter (S2) überbrückbar ist, wobei zur Umkehrung des Magnetfeldes der erste steuerbare Schalter (S1) geöffnet wird, wobei der zweite steuerbare Schalter (S2) spätestens geschloßen wird, wenn die Spannung (U_{C}) an der Kapazität (C) auf den einen Extremwert angestiegen ist, wobei der erste steuerbare Schalter (S1) frühestens geschloßen wird, wenn die Spannung (U_{C}) an der Kapazität vom einen Extremwert wieder auf null abgesunken ist, wobei zur erneuten Umkehrung des Magnetfeldes der zweite steuerbare Schalter (S2) geöffnet wird, jedoch nicht bevor die Spannung (U_{C}) an der Kapazität (C) vom einen Extremwert auf null abgesunken ist, wobei der erste steuerbare Schalter (S1) spätestens geschlossen wird, wenn die Spannung (U_{C}) an der Kapazität (C) auf den anderen Extremwert angestiegen ist, wobei der zweite steuerbare Schalter (S2) frühestens geschloßen wird, wenn die Spannung (U_{C}) an der Kapazität (C) vom anderen Extremwert wieder auf null abgesunken ist, wobei der eine Anschluß (A) des Schwingkreises mit der einen Elektrode einer dritten Diode (D3) verbunden ist, deren andere Elektrode über einen dritten steuerbaren Schalter (S3) mit dem einen Pol einer Spannungsquelle (-U) und über eine zweite Induktivität (L2) mit dem anderen Pol der Spannungsquelle (-U) verbunden ist, wobei der andere Anschluß (B) des Schwingkreises mit der einen Elektrode einer vierten Diode (D4) verbunden ist, deren andere Elektrode über einen vierten steuerbaren Schalter (S4) mit dem einen Pol der Spannungsquelle (-U) und über eine dritte Induktivität (L3) mit dem anderen Pol der Spannungsquelle (-U) verbunden ist, wobei die Steuerschaltung (S) den dritten steuerbaren Schalter (S3) eine vorgebbare Zeitspanne vor dem öffnen des ersten steuerbaren Schalters (S1) schließt und gleichzeitig mit dem ersten steuerbaren Schalters (S1) öffnet und wobei die Steuerschaltung (S) den vierten steuerbaren Schalter (S4) eine vorgebbare Zeitspanne vor dem öffnen des zweiten steuerbaren Schalters (S2) schließt und gleichzeitig mit dem zweiten steuerbaren Schalter (S2) öffnet.

3. Schaltungsanordnung nach Anspruch 1, wobei in Reihe zum dritten steuerbaren Schalter (S3) ein erster Widerstand (R1) und in Reihe zum vierten steuerbaren Schalter (S4) ein zweiter Widerstand (R2) liegt.

4. Schaltungsanordnung nach Anspruch 2, wobei zwischen dem dritten steuerbaren Schalter (S3) und dem gemeinsamen Verbindungspunkt der dritten Diode (D3) und der zweiten Induktivität (L2) eine zur dritten Diode (D3) entgegengesetzt gepolte fünfte Diode (D5) liegt und wobei zwischen dem vierten steuerbaren Schalter (S4) und dem gemeinsamen Verbindungspunkt der vierten Diode (D4) und der dritten Induktivität (L3) eine zur vierten Diode (D4) entgegengesetzt gepolte sechste Diode (D6) liegt.

5. Schaltungsanordnung nach Anspruch 1, 2, 3, oder 4, wobei eine Steuerschaltung (S) die Schaltvorgänge beim ersten und zweiten steuerbaren Schalter (S1, S2) zyklisch wiederholt.

6. Schaltungsanordnung nach Anspruch 2 oder 4, wobei ein digitales Signal (DS) am Eingang eines Schieberegisters (SR) liegt, das von einem Taktgenerator (G) getaktet wird, wobei die Signale (DS1, DS2, DS3, DS4, DS5) an den Ausgängen (T1, T2, T3, T4, T5, T6) des Schieberegisters (SR) in einer logischen Schaltung (N1, N2, N3, N4, N5, N6) miteinander verknüpft werden und wobei an den Ausgängen der logischen Schaltung (N1, N2, N3, N4, N5, N6) die Steuersignale für die steuerbaren Schalter (S1, S2, S3, S4) abnehmbar sind.

7. Schaltungsanordnung nach Anspruch 6, wobei vier Ausgänge der logischen Schaltung (N1, N2, N4, N5) mit den Eingängen zweier RS-Flip-Flops (FF1, FF2) verbunden sind, an deren Ausgängen die Steuersignale für zwei steuerbare Schalter (S3, S4) abgreifbar sind.

## Claims

1. Circuit arrangement for reversing a magnetic field, wherein a series circuit consisting of a first and a second diode (D1, D2) which are oppositely poled is connected in parallel with an oscillatory circuit consisting of a coil (L) and a capacitance (C), wherein the first diode (D1) can be shunted by a first controllable switch (S1) and the second diode (D2) by a second controllable switch (S2), wherein the first controllable switch (S1) is opened for reversing the magnetic field, wherein the second controllable switch (S2) is closed, at the latest, when the voltage (U_{C}) on the capacitance (C) has risen to the one extreme value, wherein the first controllable switch (S1) is closed, at the soonest, when the voltage (U_{C}) on the capacitance has fallen again from the one extreme value to zero, wherein the second controllable switch (S2) is opened for a renewed reversal of the magnetic field but not before the voltage (U_{C}) on the capacitance (C) has fallen from the one extreme value to zero, wherein the first controllable switch (S1) is closed, at the latest, when the voltage (U_{C}) on the capacitance (C) has risen to the other extreme value, that the second controllable switch (S2) is closed, at the soonest, when the voltage (U_{C}) on the capacitance (C) has fallen again from the other extreme value to zero, wherein the one terminal (A) of the oscillatory circuit is connected via a third controllable switch (S3) to the one pole of a voltage source (+U) and the other terminal (B) of the oscillatory circuit is connected via a fourth controllable switch (S4) to the one pole of a voltage source (+U) whose other pole is connected to the common connection point of the two diodes (D1, D2), wherein the control circuit (S) closes the third controllable switch (S3) when the first controllable switch (S1) is opened whereas the second controllable switch (S2) is closed, wherein the control circuit (S) re-opens the third controllable switch (S3) when the capacitance (C) has charged, wherein the control circuit (S) closes the fourth controllable switch (S4) when the second controllable switch (S2) is opened whereas the first controllable switch (S1) is closed and wherein the control circuit (S) re-opens the fourth controllable switch (S4) when the capacitance (C) has charged.

2. Circuit arrangement for reversing a magnetic field, wherein a series circuit consisting of a first and a second diode (D1, D2) which are oppositely poled is connected in parallel with an oscillatory circuit consisting of a coil (L) and a capacitance (C), wherein the first diode (D1) can be shunted by a first controllable switch (S1) and the second diode (D2) by a second controllable switch (S2), wherein the first controllable switch (S1) is opened for reversing the magnetic field, wherein the second controllable switch (S2) is closed at the latest, when the voltage (U_{C}) on the capacitance (C) has risen to the one extreme value, wherein the first controllable switch (S1) is closed, at the soonest, when the voltage (U_{C}) on the capacitance (C) has fallen again from the one extreme value to zero, wherein the second controllable switch (S2) is opened for a renewed reversal of the magnetic field but not before the voltage (U_{C}) on the capacitance (C) has fallen from the one extreme value to zero, wherein the first controllable swich (S1) is closed, at the latest, when the voltage (U_{C}) on the capacitance (C) has risen to the other extreme value, wherein the second controllable switch (S2) is closed, at the soonest, when the voltage (U_{C}) on the capacitance (C) has fallen again from the other extreme value to zero, wherein the one terminal (A) of the oscillatory circuit is connected to the one electrode of a third diode (D3) whose other electrode is connected via a third controllable switch (S3) to the one pole of a voltage source (-U) and via a second inductance (L2) to the other pole of the voltage source (-U), wherein the other terminal (B) of the oscillatory circuit is connected to the one electrode of a fourth diode (D4) whose other electrode is connected via a fourth controllable switch (S4) to the one pole of the voltage source (-U) and via a third inductance (L3) to the other pole of the voltage source (-U), wherein the control circuit (S) closes the third controllable switch (S3) a predetermined period of time before the opening of the first controllable switch (S1) and opens it simultaneously with the first controllable switch (S1) and wherein the control circuit (S) closes the fourth controllable switch (S4) a predetermined period of time before the opening of the second controllable switch (S2) and opens it simultaneously with the second controllable switch (S2).

3. Circuit arrangement in accordance with Claim 1, wherein a first resistance (R1) is in series with the third controllable switch (S3) and a second resistance (R2) is in series with the fourth controllable switch (S4).

4. Circuit arrangement in accordance with Claim 2, wherein a fifth diode (D5) which is oppositely poled to the third diode (D3) is located between the third controllable switch (S3) and the common connection point of the third diode (D3) and the second inductance (L2) and wherein a sixth diode (D6) which is oppositely poled to the fourth diode (D4) is located between the fourth controllable switch (S4) and the common connection point of the fourth diode (D4) and the third inductance (L3).

5. Circuit arrangement in accordance with Claim 1, 2, 3 or 4, wherein a control circuit (S) cyclically repeats the switching sequences of the first and second controllable switches (S1, S2).

6. Circuit arrangement in accordance with Claim 2 or 4, wherein a digital signal (DS) is present on the input of a shift register (SR) which is clocked by a clock pulse generator (G), wherein the signals (DS1, DS2, DS3, DS4, DS5) at the outputs (T1, T2, T3, T4, T5, T6) of the shift register (SR) are logically combined in a logic circuit (N1, N2, N3, N4, N5, N6) and wherein the control signals for the controllable switches (S1, S2, S3, S4) are derivable from the outputs of the logic circuit (N1, N2, N3, N4, N5, N6).

7. Circuit arrangement in accordance with Claim 6, wherein four outputs of the logic circuit (N1, N2, N3, N4, N5, N6) are connected to the inputs of two RS flip-flop (FF1, FF2) from whose outputs the control signals for two controllable switches (S3, S4) are derivable.

## Revendications

1. Circuit pour inverser le champ magnétique, un montage en série constitué par une première et une seconde diode (D1, D2), qui sont polarisées de sens inverse, étant monté en parallèle avec un circuit oscillant constitué par une bobine (L) et un condensateur (C), la première diode (D1) pouvant être pontée par un premier commutateur qui peut être commandé (S1) et la seconde diode (D2) pouvant être pontée par un second commutateur qui peut être commandé (S2), le premier commutateur qui peut être commandé (S1) étant ouvert pour inverser le champ magnétique, le second commutateur qui peut être commandé (S2) étant fermé au plus tard lorsque la tension (U_{C}) au condensateur (C) est montée à l'une des valeurs extrêmes, le premier commutateur qui peut être commandé (S1) étant fermé au plus tôt lorsque la tension (U_{C}) au condensateur est baissée d'une des valeurs extrêmes à nouveau à zéro, le second commutateur qui peut être commandé (S2) étant ouvert pour la nouvelle inversion du champ magnétique, cependant pas avant avant que la tension (U_{C}) au condensateur (C) n'ait baissé de l'une des valeurs extrêmes à zéro, le premier commutateur qui peut être commandé (S1) étant fermé au plus tard lorsque la tension (U_{C}) au condensateur (C) est montée à l'autre valeur extrême, le second commutateur qui peut être commandé (S2) étant au plus tôt fermé lorsque la tension (U_{C}) au condensateur (C) a baissé de l'autre valeur extrême à nouveau à zéro, l'un des raccords (A) du circuit oscillant étant relié par un troisième commutateur qui peut être commandé (S3) et l'autre raccord (B) du circuit oscillant par un quatrième commutateur qui peut être commandé (S4) à l'un des pôles d'une source de tension (+U) dont l'autre pôle est relié au point de jonction commun des deux diodes (D1, D2), le circuit de commande (S) fermant le troisième commutateur qui peut être commandé (S3), lorsque le premier commutateur qui peut être commandé (S1) est ouvert et que, par contre, le second commutateur qui peut être commandé (S2) est fermé, le circuit de commande (S) ouvrant à nouveau le troisième commutateur qui peut être commandé (S3) lorsque le condensateur (C) est chargé, le circuit de commande (S) fermant le quatrième commutateur qui peut être commandé (S4) lorsque le second commutateur qui peut être commandé (S2) est ouvert et que, par contre, le premier commutateur qui peut être commandé (S1) est fermé et le circuit de commande (S) ouvrant à nouveau le quatrième commutateur qui peut être commandé (S4) lorsque le condensateur (C) est chargé.

2. Circuit pour inverser le champ magnétique, un montage en série constitué par une première et une seconde diode (D1, D2), qui sont polarisées de sens inverse, étant monté en parallèle avec un circuit oscillant constitué par une bobine (L) et un condensateur (C), la première diode (D1) pouvant être pontée par un premier commutateur qui peut être commandé (S1) et la seconde diode (D2) pouvant être pontée par un second commutateur qui peut être commandé (S2), le premier commutateur qui peut être commandé (S1) étant ouvert pour inverser le champ magnétique, le second commutateur qui peut être commandé (S2) étant fermé au plus tard lorsque la tension (U_{C}) au condensateur (C) est montée à l'une des valeurs extrêmes, le premier commutateur qui peut être commandé (S1) étant fermé au plus tôt lorsque la tension (U_{C}) au condensateur est baissée d'une des valeurs extrêmes à nouveau à zéro, le second commutateur qui peut être commandé (S2) étant ouvert pour la nouvelle inversion du champ magnétique, cependant pas avant avant que la tension (U_{C}) au condensateur (C) n'ait baissé de l'une des valeurs extrêmes à zéro, le premier commutateur qui peut être commandé (S1) étant fermé au plus tôt lorsque la tension (U_{C}) au condensateur (C) est montée à l'autre valeur extrême, le second commutateur qui peut être commandé (S2) étant au plus tôt fermé lorsque la tension (U_{C}) au condensateur (C) a baissé de l'autre valeur extrême à nouveau à zéro, l'un des raccords (A) du circuit oscillant étant relié à l'une des électrodes d'une troisième diode (D3) dont l'autre électrode est reliée par un troisième commutateur qui peut être commandé (S3) à l'un des pôles d'une source de tension (-U) et par une seconde inductance (L2) à l'autre pôle de la source de tension (-U), l'autre raccord (B) du circuit oscillant étant relié à l'une des électrodes d'une quatrième diode (D4) dont l'autre électrode est reliée par un quatrième commutateur qui peut être commandé (S4) à l'un des pôles de la source de tension (-U) et par une troisième inductance (L3) à l'autre pôle de la source de tension (-U), le circuit de commande (S) fermant le troisième commutateur qui peut être commandé (S3) pendant une période de temps qui peut être prédéfinie avant d'ouvrir le premier commutateur qui peut être commandé (S1) et l'ouvrant simultanément avec le premier commutateur qui peut être commandé (S1) et le circuit de commande (S) fermant le quatrième commutateur qui peut être commandé (S4) pendant une période de temps qui peut être prédéfinie avant d'ouvrir le second commutateur qui peut être commandé (S2) et l'ouvrant simultanément avec le second commutateur qui peut être commandé (S2).

3. Circuit selon la revendication 1, une première résistance (R1) étant montée en série avec le troisième commutateur qui peut être commandé (S3) et une seconde résistance (R2) étant montée en série avec le quatrième commutateur qui peut être commandé (S4).

4. Circuit selon la revendication 2, une cinquième diode (D5), polarisée de sens opposé à la troisième diode (D3), se trouvant entre le troisième commutateur qui peut être commandé (S3) et le point de jonction commun de la troisième diode (D3) et de la seconde inductance (L2) et une sixième diode (D6), polarisée de sens opposé à la quatrième diode (D4), se trouvant entre le quatrième commutateur qui peut être commandé (S4) et le point de jonction commun de la quatrième diode (D4) et de la troisième inductance (L3).

5. Circuit selon la revendication 1, 2, 3 ou 4, un circuit de commande (S) répétant les opérations de commutation de manière cyclique pour le premier commutateur qui peut être commandé et le second commutateur qui peut être commandé (S1, S2).

6. Circuit selon la revendication 2 ou 4, un signal numérique (DS) se trouvant à l'entrée d'un registre à décalage (SR), qui est commandé par un générateur de cycle (G), les signaux (DS1, DS2, DS3, DS4, DS5) aux sorties (T1, T2, T3, T4, T5, T6) du registre à décalage (SR) étant enchaînés les uns aux autres dans un circuit logique (N1, N2, N3, N4, N5, N6) et les signaux de commande pour les commutateurs qui peuvent être commandés (S1, S2, S3, S4) pouvant être prélevés aux sorties du circuit logique (N1, N2, N3, N4, N5, N6).

7. Circuit selon la revendication 6, quatre sorties du circuit logique (N1, N2, N4, N5) étant reliées aux entrées de deux bascules RS (FF1, FF2) aux sorties desquelles les signaux de commande pour deux commutateurs qui peuvent être commandés (S3, S4) pouvant être prélevés.
